# EUROPEAN PATENT SPECIFICATION

(11) **EP 0 444 205 B1**
(45) Date of publication and mention of the grant of the patent: **27.12.1995**
(21) Application number: 90913542.8
(22) Date of filing: 14.09.1990
(51) Int. Cl.: H01L 21/205, C23C 16/44, C30B 25/14

(54) **SUBSTRATE SUPPORT DEVICE FOR CVD APPARATUS**
SUBSTRATTRÄGERANORDNUNG FÜR CHEMISCHE DAMPFNIEDERSCHLAGVORRICHTUNG
DISPOSITIF DE SUPPORT DE SUBSTRAT POUR APPAREIL CVD

(30) Priority: 21.09.1989 JP 109677/89
(43) Date of publication of application: 04.09.1991
(73) Proprietor: ASM JAPAN K.K., Tokyo 206 (JP); NEC CORPORATION, Minato-ku Tokyo (JP)
(72) Inventor: SHUTO, Mitsutoshi ASM Japan K.K., Tama-shi Tokyo 206 (JP); HUKAZAWA, Yasushi ASM Japan K.K., Tama-shi Tokyo 206 (JP); OHSAKI, Minoru NEC Kyushu, Ltd. 100, Yahata-machi, Kumamoto 861-41 (JP)
(74) Representative: de Bruijn, Leendert C.
(86) International application number: JP9001182
(87) International publication number: WO9104572

(56) References cited:
- EP-A- 0 029 146
- DE-A- 3 216 465
- JP-A- 5 081 677
- JP-A-63 181 315
- US-A- 3 678 893
- US-A- 4 421 786

## Description

### Technical Field

This invention pertains to an apparatus for supporting a plurality of substrates like semiconductor wafers and so on, and a CVD apparatus which deposits a predetermined thin film on substrates by using the supporting apparatus.

### Background Art

Recently, electronic parts used in machines for office automation, televisions, computers and so on have been rapidly developed. Semiconductor devices are used in such electronic parts. In process for making semiconductor devices, a CVD apparatus is used in order to deposit a thin film like an oxide film or polycrystalline silicon film on a semiconductor substrate. In such a CVD apparatus, there is a vertical-type CVD apparatus in which a plurarity of substrates are arranged vertically and a horizontal-type CVD apparatus in which a plurarity of substrates are arranged horizontally. Such type of CVD apparatus can treat a plurarity of substrates at once.

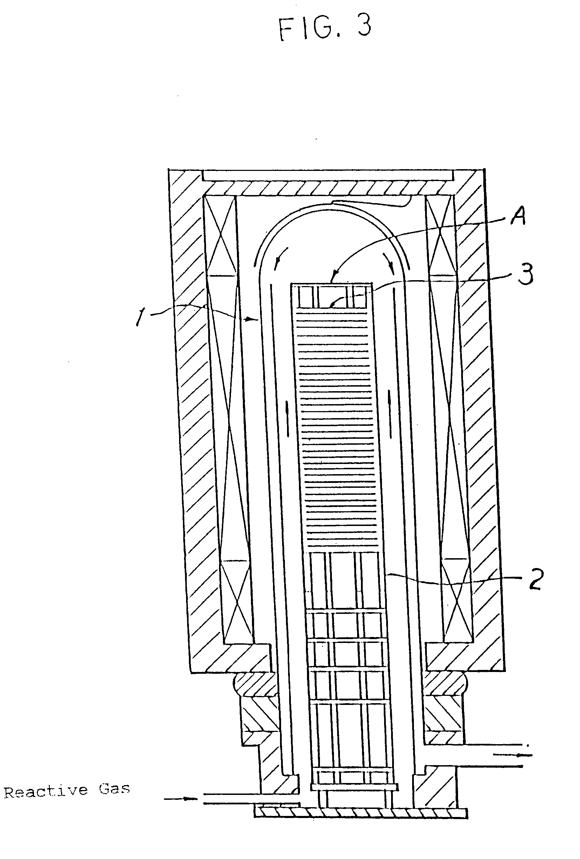

A partly sectional fragmentary schematic illustration of a prior art horizontal CVD apparatus is shown in Fig. 3. A substrate supporting apparatus A which has four supporting bars 2 and a plurality of support plates 3 supported by the bars 2 is positioned in a bell-jar type silica tube 1.

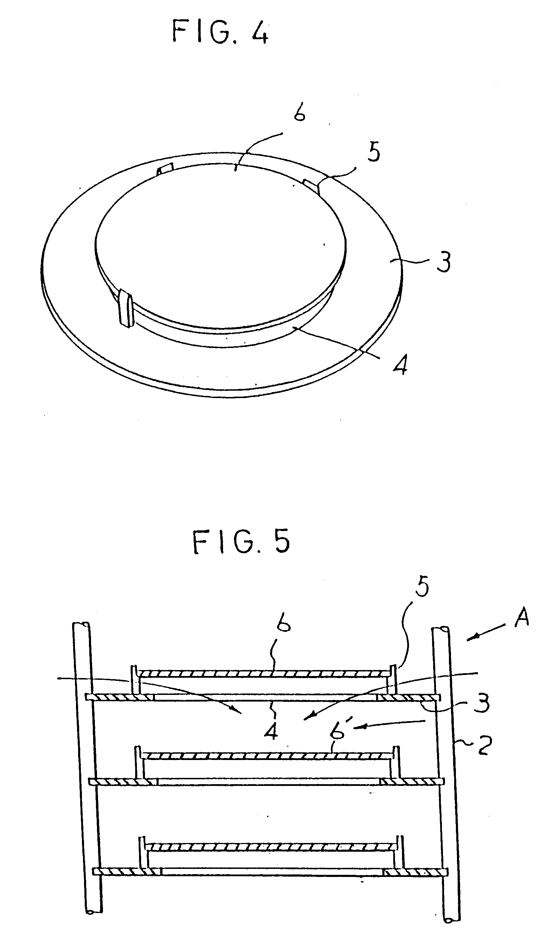

Fig. 4 illustrates the support plate 3 supporting substrates and Fig. 5 shows a fragmentary sectional view of the substrate supporting apparatus in which the plates are positioned equally and in parallel. The plates have the same structure and have the same opening. Fig. 5 illustrates three support plates, but the illustrated plates are a part of plural plates positioned in parallel. As shown in Fig. 4, each of the plates has a central opening 4, and has plural clips 5 for supporting substrate 6 along the periphery of the opening. The openings are substantially indentical. The reason the substrates are supported by such plates is as follows. That is, as shown in Fig. 5, a reactive gas necessary to deposit a thin film on a substrate does not only flow from between the support plates into the substrate but also flow from an opening of a plate positioned over the plate which supports the substrate into the substrate. The reactive gas reaches comparatively uniformly the substrate, thus a thin uniform film can be deposited on the substrate.

However, the CVD apparatus in which such a substrate supporting apparatus is incorporated has following disadvantages.

In the substrate supporting apparatus A having identical plates which are positioned equally and in parallel as shown in Fig. 5, it is possible to deposit a thin uniform film on each of the substrates on condition that a reactive gas among the plates is in the same condition. However, flowing, temperature, pressure of such the reactive gas which flows around support plates positioned upstream are different from those of the reactive gas which flows around support plates positioned downstream. In a result, a central part of film deposited on the substrate positioned upstream is thicker than the peripheral part of the film, the peripheral part of a film deposited on the substrates positioned downstream is thicker than a central part of the films. Such a film is deposited on substrates positioned upstream and substrates positioned downstream in a horizontal-type CVD apparatus, too. Deposition of such an ununiform film cannot be tolerated in semiconductor manufacturing in which it is required to precisely deposit an uniform film on a substrate.

It is therefore a objective of the present invention to provide a substrate supporting apparatus for treating simultaneously plural semicondutor subatrates in a CVD apparatus, improving uniformity of a thin film deposited on the subatrates, and/or controlling properly a concentration of an impurity to be introduced in the film.

### Disclosure of Invention

According to the present invention, the above objects are achieved in a substrate supporting apparatus comprising a plurality of support plates positioned in parallel one over the other for supporting a plurality of substrates to be treated, respectively. Each of the support plates has a central opening, and has a plurality of clips along the periphery of the opening to carry a substrate above the opening. The openings in the support plates exhibit at least two different sizes.

A CVD apparatus of the present invention includes said substrate supporting apparatus.

Besides, the substrate, support plates, and openings in the support plates may be circular, or polygonal. A substrate to be treated is not limited to a semiconductor, for example may be a glass substrate, or a ceramic substrate.

A space needed to deposit a uniform thin film on a substrate under various conditions ( e.g. temperature, pressure, flowing and so on) of a gas or gases surrounding the substrate is defined by varying the size of an opening in a support plate of a substrate supporting apparatus of the present invention so that treatment of a plurality of substrates, that is. uniform thin film deposition can be achieved. The present invention can control properly a concentration of an impurity to be introduced in the film, too.

### Brief Description of Drawings

Fig. 1 is a partially sectional view of the substrate supporting apparatus according to the invention.

Fig. 2 is a partially sectional view of the alternate embodiment of the substrate supporting apparatus according to the invention incorporated in a hot-wall type CVD apparatus.

Fig. 3 is a sectional schematic view of a bell-jar CVD apparatus including a prior art substrate supporting apparatus.

Fig. 4 is a perspective view of support plates in a prior art substrate supporting apparatus.

Fig. 5 is a partially sectional view of a prior art substrate supporting apparatus.

### Best Mode for Carrying Out the Invention

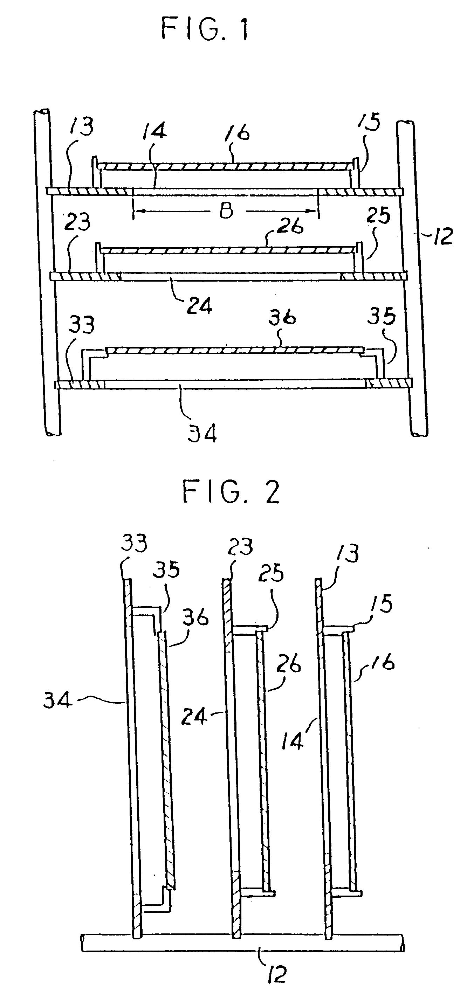

Fig. 1 is a partially sectional view of the substrate supporting apparatus according to the invention which is incorporated in a vertical CVD apparatus. Fig. 1 shows only three support plates 13, 23, 33 carried in parallel by supporting bars, actually the number of support plates to be properly positioned in a CVD apparatus depends on the volume of a CVD apparatus to be used. The basic structure of each of these support plates is the same as one of the support plates shown in Fig. 4.

The plates 13, 23, 33 supporting substrates, as well as the plates shown in Fig. 4 are circular, but are not limited to be circular, they may be polygonal. However, if substrates to be treated are circular, these plates prefer to be circular.

The plates 13, 23, and 33 have central openings 14, 24, and 34, respectively through which a reactive gas may flow. These opening are circular, since the substrates are circular. Clips for supporting a substrate above the plate are mounted on the plate along the periphery of the opening. The number of clips should be decided in view of reliability in clipping a substrate and facility in attaching or removing a substrate. By the clips, a substrate is supported right above the opening of the support plate.

The substrate is a semiconductor wafer, but is not limited to such a semiconductor wafer, for example may be a glass substrate, or a ceramic substrate.

The structure of the plates of the substrate supporting apparatus of the present invenion is basically the same as the structure of the prior art plate shown in Fig. 4. The difference between the substrate supporting apparatus of the present invention and the prior art substrate supporting apparatus is clear as compared with Fig.1 and Fig. 5, that is that openings in the plate of the prior art apparatus are the same, on the other hand openings in the plate of the apparatus of the present invention are different to each other.

In the preferable embodiment (Fig. 1) of the substrate supporting apparatus incorporated in the vertical CVD apparatus shown in Fig. 3, the sizes of openings 14, 24, and 34 in the plates 13, 23, and 33 increase gradually (for example, when a semiconductor wafer is 150 mm in diameter, the opening in the highest plate is 146 mm in diameter and the opening in the lowest plate is 158 mm in diameter). However, when the sizes of openings in plates positioned downstream increase gradually, the opening 34 in the support plates 33 becomes larger than the substrate 36 as shown in Fig. 1. In the case, the substrate 36 is supported by inverse L-shaped clips 35.

A space above a substrate needed to deposit a uniform thin film on the substrate which depends on various conditions (e.g. temperature, pressure, flowing and so on) of a gas or gases surrounding the substrate is defined above the substrate by changing the size of the opening (D shown in Fig. 1) of the support plate positioned above the substrate. However, since the sizes of openings in the support plates should be changed to define the above-mentioned space above the substrate to be treated, all the sizes of the openings need not be different to each other. In the simplest embodiment, upper half of the support plates have the same small opening, respectively, and lower half of the support plates have the same large openings, respectively.

Fig. 1 shows a substrate supporting apparatus having support plates with openings. As shown in Fig. 1, the more downstream the support plates are positioned, the larger the openings become, this is one embodiment incorporated into a general vertical CVD apparatus. If conditions of the reactive gas surrounding each of support plates changes depending upon CVD apparatus type to be used, the number of substrates to be treated, the kind of reactive gas, reaction condition, treating time and so on, each of the sizes (B) of the support plates needs be varied according to the change of the gas conditions.

Therefore, in one embodiment, the openings in the upper and lower plates are smallest and the opening in the middle plate is largest, in other embodiment, the opening in the upper plate is largest and the opening in the lower plate is smallest.

The sizes of the support plates of the substrate supporting apparatus should be individually decided according to operation condition of the CVD apparatus.

It is apparant that a substrate supporting apparatus which has a plurality of support plates having different central openings, respectively, according to the present invention, also can control properly a concentration of an impurity to be introduced in a film on the substrate.

Fig. 2 shows an alternate embodiment of the present invention and is a partially sectional view of the substrate supporting apparatus incorporated in a hot-wall type CVD apparatus, which comprises a plurality of support plates 13, 23, and 33 arranged in vertical and in parallel for supporting substrates 16, 26, 36 by means of clips 15, 25, 35.

### Industrial Applicability

As explained, the substrate supporting apparatus of the present invention is suitable to a CVD apparatus for depositing a uniform thin film on a substrate or controlling a concentration of a impurity to be introduced in a deposited thin film on a substrate depending upon conditions of a reactive gas (temperature, pressure, flowing).

## Claims

1. A substrate supporting apparatus having a plurality of support plates positioned in parallel one over the other for supporting a plurality of substrates to be treated, each of said plates having a central opening and a plurality of clips along the periphery of the opening for supporting a substrate above the opening, said openings in said plates exhibiting at least two different sizes.

2. A CVD apparatus for depositing thin films on a plurality of substrates, characterized in that substrate supporting apparatus having a plurality of support plates positioned in parallel one over the other for supporting a plurality of substrates is positioned in the CVD apparatus, each of said plates having a central opening and a plurality of clips along the periphery of the opening for supporting a substrate above the opening, said openings in said plates exhibiting at least two different sizes.

## Patentansprüche

1. Substrattragender Apparat, der eine Anzahl von Tragplatten aufweist, die parallel, eine über der anderen angeordnet sind, um eine Anzahl von zu behandelnden Substraten zu tragen, wobei jede der Platten eine mittige Öffnung und eine Anzahl an Klemmeinrichtungen entlang des Umfangs der Öffnung aufweist, um ein Substrat oberhalb der Öffnung zu tragen, wobei die Öffnungen in den Platten wenigstens zwei verschiedene Grössen aufweisen.

2. CVD-Apparat zum Niederschlagen dünner Schichten auf einer Anzahl von Substraten, **dadurch gekennzeichnet, dass** ein substrattragender Apparat, der eine Anzahl von Tragplatten aufweist, die parallel, eine über der anderen angeordnet sind, um eine Anzahl von Substraten zu tragen, in dem CVD-Apparat positioniert ist, wobei jede der Platten eine mittige Öffnung und eine Anzahl von Klemmeinrichtungen entlang des Umfangs der Öffnung aufweist, um ein Substrat oberhalb der Öffnung zu tragen, wobei die Öffnungen in den Platten wenigstens zwei verschiedene Grössen aufweisen.

## Revendications

1. Dispositif de support de substrat comportant une pluralité de plaques de support disposées en parallèle les unes au dessus des autres pour supporter une pluralité de substrats devant subir un traitement, chacune desdites plaques ayant un orifice central et une pluralité de pinces sur la périphérie de l'orifice pour supporter un substrat au-dessus de l'orifice, lesdits orifices dans lesdites plaques ayant au moins deux tailles différentes.

2. Appareil de dépôt chimique à partir d'une phase gazeuse (CVD) servant à déposer de minces couches sur une pluralité de substrats, caractérisé en ce qu'un dispositif de support de substrat comportant une pluralité de plaques de support disposées en parallèle les unes au dessus des autres pour supporter unepluralité de substrats est placé dans ledit appareil de dépôt CVD, chacune desdites plaques ayant un orifice central et une pluralité de pinces sur la périphérie de l'orifice pour supporter un substrat au-dessus de l'orifice, lesdits orifices dans lesdites plaques ayant au moins deux tailles différentes.
